# EUROPÄISCHE PATENTSCHRIFT

(11) **EP 2 761 643 B1**
(45) Veröffentlichungstag und Bekanntmachung des Hinweises auf die Patenterteilung: **12.07.2023**
(21) Anmeldenummer: 12772719.6
(22) Anmeldetag: 28.09.2012
(51) Int. Cl.: H01J 37/32, H01J 37/34, C23C 14/00, C23C 14/02, C23C 14/50, C23C 14/56, C23C 14/52

(54) **VERFAHREN UND VORRICHTUNG ZUR ERZEUGUNG EINER REFLEKTIONSMINDERNDEN SCHICHT AUF EINEM SUBSTRAT**
METHOD AND APPARATUS FOR PRODUCING A REFLECTION REDUCING LAYER ON A SUBSTRATE
PROCÉDÉ ET DISPOSITIF DE PRODUCTION D'UNE COUCHE DIMINUANT LES RÉFLÉCHISSEMENTS SUR UN SUBSTRAT

(30) Priorität: 28.09.2011 DE 102011114450
(43) Veröffentlichungstag der Anmeldung: 06.08.2014
(73) Patentinhaber: Bühler Alzenau GmbH, 63755 Alzenau (DE)
(72) Erfinder: SCHERER, Michael, 63796 Kahl (DE); PISTNER, Jürgen, 63755 Alzenau-Michelbach (DE); HAGEDORN, Harro, 60435 Frankfurt am Main (DE); KLOSCH-TRAGESER, Michael, 63579 Freigericht-Neuses (DE)
(74) Vertreter: Vossius & Partner Patentanwälte Rechtsanwälte mbB
(86) Internationale Anmeldenummer: PCT/EP2012/004093
(87) Internationale Veröffentlichungsnummer: WO 2013/045111

(56) Entgegenhaltungen:
- EP-A1- 1 630 248
- WO-A1-2010/124836
- WO-A2-2004/050944
- DE-A1-102004 036 170
- DE-A1-102006 056 578
- US-A1- 2011 168 544

## Beschreibung

Die Erfindung betrifft ein Verfahren zur Erzeugung einer reflektionsmindernden Schicht auf einer Oberfläche eines Kunststoffsubstrats. Weiterhin betrifft die Erfindung eine Vorrichtung zur Durchführung dieses Verfahrens.

Bei der Herstellung optischer Komponenten aus transparentem Kunststoff ist es oftmals wünschenswert, diese Komponenten zu entspiegeln und dadurch die optischen Eigenschaften dieser Komponenten zu verbessern. Eine solche Entspiegelung kann dadurch erreicht werden, dass man auf die Oberfläche des Substrats eine Antireflektionsbeschichtung, insbesondere in Form eines Multischichtsystems, aufbringt. Alternativ kann die Oberfläche mit einer Mikro- oder Nanostruktur versehen werden; eine solche Strukturierung hat den Vorteil, dass eine breitbandige Entspiegelung mit guter Reproduzierbarkeit erzielt werden kann.

Die DE 102 41 708 B4 beschreibt ein Verfahren zur Reduktion der Reflektion von Kunststoffsubstraten, bei dem an einer Oberfläche des Kunststoffsubstrates mit Hilfe eines Plasmaätzprozesses eine Nanostruktur gebildet wird. Diese Nanostruktur wird durch Beschuss der Substratoberfläche mit energiereichen Ionen hergestellt, die durch eine Plasma-Ionenquelle erzeugt werden. Allerdings ist dieses Ätzverfahren mit vergleichsweise langen Prozesszeiten verbunden. Weiterhin sind die Prozesszeiten für unterschiedliche Substratwerkstoffe stark unterschiedlich, was die Bearbeitung unterschiedlicher Materialien in einem Arbeitsgang erschwert.

Zur Lösung dieses Problems schlägt die gattungsbildende DE 10 2006 056 578 A1 vor, vor dem Plasmaätzprozess eine dünne Schicht, insbesondere eine dünne Oxidschicht, auf das Kunststoffsubstrat aufzubringen. Diese Oxidschicht führt zu einer Verkürzung der Prozesszeiten beim anschließenden Plasmaätzprozess und hat weiterhin den Effekt, dass sich die erforderlichen Prozesszeiten für unterschiedliche Werkstoffe nur noch unwesentlich voneinander unterscheiden. Die dünne Schicht wird vorzugsweise durch reaktives Sputtern erzeugt. Nach Aufbringen der dünnen Schicht wird mittels Plasmaätzen eine Nanostruktur auf der Substratoberfläche erzeugt, die sich typischerweise zwischen 50 nm und 200 nm in das Kunststoffsubstrat hinein erstreckt. Danach kann eine transparente Schutzschicht aufgetragen werden, die die Nanostruktur vor äußeren Einwirkungen, insbesondere vor mechanischen Beschädigungen schützt.

In der DE 10 2005 049 280 A1 wird ein Verfahren zu Erzeugung einer Nanostruktur auf einer Oberfläche eines Kunststoffsubstrats vorgeschlagen, bei dem zunächst eine gleichförmige Trägerschicht und anschließend eine inselförmige Schicht auf die Oberfläche aufgebracht wird. Die inselförmige Schicht wirkt als Maskenschicht in einem darauffolgenden Ätzprozess, bei dem eine Strukturierung der Trägerschicht erfolgt. Der Ätzprozess kann beispielsweise mittels reaktiven lonenätzens durchgeführt werden. Die strukturierte Trägerschicht dient als Ätzmaske in einem weiteren Ätzprozess, bei dem auf der Oberfläche des Substrats die gewünschte Nanostruktur erzeugt wird.

Aus der DE 10 2007 059 886 A1 ist weiterhin ein Verfahren zur Nanostrukturierung einer Oberfläche aufgetragen und durch Bestrahlung mit UV-Licht oder durch Tempern teilweise verfestigt wird. Anschließend wird durch ein Plasmaätzverfahren an der Oberfläche der Lackschicht eine Nanostruktur erzeugt. Danach wird die nanostrukturierte Lackschicht durch eine weitere Bestrahlung mit UV-Licht oder durch weiteres Tempern vollständig ausgehärtet.

Während diese Schriften unterschiedliche Verfahren zu Herstellung reflektionsmindernder Beschichtungen für optische Elemente offenbaren, machen sie keinerlei Vorschläge für eine Vorrichtung, die sich für eine großserienfähige Herstellung solcher Beschichtungen eignet. Herkömmlicherweise kommen für die Durchführung solcher Verfahren Anlagen zum Einsatz, die im Batchbetrieb arbeiten, weswegen die Anlage zwischen den einzelnen Prozessschritten belüftet werden muss. Durch dieses ständige Belüften der Anlage nach jedem Bearbeitungsschritt und die damit verbundene fluktuierende Restgaszusammensetzung leidet die Reproduzierbarkeit der auf dem Substrat erzeugten Oberflächenbearbeitung. Weiterhin ist aufgrund langer Chargier- und Pumpzeiten der Durchsatz dieser Anlagen begrenzt. Die homogene Abscheidung dünner Schichten auf allen Substraten einer Charge gestaltet sich als schwierig, wodurch die Reproduzierbarkeit innerhalb einer Charge leidet.

DE 10 2004 036170 A1 beschreibt eine Vakuumbeschichtungsanlage und ein Verfahren zur Vakuumbeschichtung mit einem ersten Beschichtungsbereich einer Vakuumkammer mit wenigstens einer Einrichtung zur plasmaimpuls-induzierten chemischen Dampfphasenabscheidung und zumindest einem zweiten Beschichtungsbereich mit wenigstens einer Einrichtung zur Sputterbeschichtung.

Der Erfindung liegt somit die Aufgabe zugrunde, ein Verfahren und eine Vorrichtung bereitzustellen, mittels derer die Oberfläche von Kunststoffsubstraten durch eine Plasmabehandlung derart modifiziert werden kann, dass eine wirksame Entspiegelung der Kunststoffoberfläche erreicht wird. Die Vorrichtung soll eine gute Reproduzierbarkeit gewährleisten, einfach und kostengünstig durchzuführen sein und einen hohen Durchsatz und einen vollautomatischen Prozessablauf ermöglichen.

Die Erfindung wird durch die Merkmale der unabhängigen Ansprüche definiert. Vorteilhafte Ausgestaltungen sind Gegenstand der Unteransprüche.

Die erfindungsgemäße Vorrichtung zur Oberflächenbehandlung von Kunststoffsubstraten umfasst eine Vakuumkammer, in der diejenigen Prozessstationen, die zu dieser Oberflächenbehandlung benötigt werden, gemeinsam aufgenommen sind. Die Kunststoffsubstrate können aus PMMA, Polycarbonat oder dergleichen Kunststoffen, die für optische Anwendungen wie Linsen geeignet sind, bestehen. Die Kunststoffsubstrate befinden sich auf einer Fördervorrichtung, mit deren Hilfe sie von Prozessstation zu Prozessstation bewegt werden.

Eine erste Prozessstation ist eine Sputterstation, in der mittels einer ersten Sputtereinrichtung eine Grundschicht auf das Substrat aufgebracht wird. Die zweite Prozessstation umfasst eine Plasmaquelle und dient zur Plasmaätzbehandlung der beschichteten Substratoberfläche. Vorzugsweise in einer weiteren Sputterstation wird mittels einer zweiten Sputtereinrichtung eine Schutzschicht auf die bearbeitete Substratoberfläche aufgebracht. Weiterhin umfasst die Vorrichtung Zuführungen zum kontrollierten Einlassen von Prozessgasen in den Prozessstationen, und Schleusen zum Ein- und Ausführen der Substrate unter Vakuum.

Im Unterschied zu herkömmlichen Beschichtungsvorrichtungen, die im Batchbetrieb arbeiten, ermöglicht die erfindungsgemäße Vorrichtung eine qualitativ hochwertige, effiziente und kostengünstige Oberflächenbehandlung von Kunststoffsubstraten. Das Restgasniveau im Inneren der Vakuumkammer ist gering und die Restgaszusammensetzung ist konstant, was eine reproduzierbare Prozessführung gestattet. Zudem ermöglicht die erfindungsgemäße Vorrichtung einen vollautomatischen Prozessablauf (z.B. zur Entspiegelung kleiner Kunststofflinsen).

Als Plasmaquelle wird vorzugsweise eine aus der DE 10 2009 018 912 A1 bekannte Plasmaquelle verwendet. Diese Plasmaquelle umfasst einen Plasmaraum, eine Anregungselektrode und einen magnetischen Nord- und einen magnetischen Südpol, wobei die beiden magnetischen Pole jeweils auf einer einem Plasma abgewandten Seite hinter der Anregungselektrode angeordnet und in das Innere des Plasmaraums gerichtet sind. Auf diese Weise wird ein gekrümmtes, in das Innere des Plasmaraums hineinragendes Magnetfeld und ein tunnelartiger Bereich gebildet, in dem geladene Teilchen gehalten werden können und entlang welchem sie sich ausbreiten können. Diese Plasmaquelle zeichnet sich durch eine besonders geringe thermische Abstrahlung aus, was für die Plasmabehandlung von Kunststoffsubstraten von entscheidender Bedeutung ist. Dadurch können sowohl bei dem reaktiven plasmaunterstützten Aufträgen von Grund- und Schutzschicht als auch bei dem reaktiven Plasmaätzprozess geringe Temperaturen des Substrats von weit unterhalb von 100° C, beispielsweise bei Substrattemperaturen von < 80°C, insbesondere <60°C erzielt werden.

Ferner kann, zumindest mit der angegebenen Plasmaquelle aus der DE 10 2009 018 912 A1, und ferner zumindest bei Substrattemperaturen von < 80°C, bevorzugt < 60°C, bzw. bei Substrattemperaturen in einem Bereich zwischen 50°C und 80°C, das Verfahren bei einem Abstand zwischen dem Gitter der Plasmaquelle zur Substratoberfläche von 50 - 100mm durchgeführt werden, ohne dass durch einen übermäßig hohen Energieeintrag in das Substrat kommt, insbesondere bei einer Plasmaleistung zwischen 200 Watt bis 400 Watt. Die Leistungsdichte der Plasmaquelle bezogen auf Fläche Extraktionselektrode beträgt 0,5 - 1,5W/cm².

Die Fördervorrichtung dient zum kontinuierlichen und wiederholten Transport der Kunststoffsubstrate von Prozessstation zu Prozessstation. Als Fördervorrichtung wird vorzugsweise ein Drehteller verwendet, mit dem hohe Drehgeschwindigkeiten von bis zu 240 rmp erreicht werden können. Diese hohen Fördergeschwindigkeiten gewährleisten - auch beim Auftrag dünner Schichten - homogene Schichtdicken auf allen Kunststoffsubstraten einer Charge, was eine hohe Reproduzierbarkeit innerhalb dieser Charge sicherstellt. Eine bevorzugte Ausführungsform der Konfiguration Fördervorrichtung - Sputtereinrichtung - Plasmaquelle - Sputtereinrichtung ist in der WO 2004/050944 der Anmelderin dargestellt.

Ferner kann die Vorrichtung als In-Line - Anlage mit einer Anordnung von Bearbeitungsstationen entlang der Fördervorrichtung ausgebildet sein: Sputtereinrichtung - Plasmaquelle - Sputtereinrichtung sowie optional zusätzliche einer Top-Coatquelle.

Für die Behandlung größerer Kunststoffsubstrate kann als Fördervorrichtung eine Trommelanlage zum Einsatz kommen. Hier sind die Substrate auf der Außenwand einer drehbaren Trommel angeordnet, und die Bearbeitungseinrichtungen bzw. Quellen befinden sich gegenüber der Außenseite dieser Trommel.

Zweckmäßigerweise ist eine Messeinrichtung zur In-Situ-Messung der Transmission und/oder der Reflektion des Substrats vorgesehen. Diese Messvorrichtung dient zur Überwachung des Substrats während des gesamten Behandlungsprozesses und zur automatischen Abschaltung mindestens der aktiven Plasmaätzbehandlung.

Das erfindungsgemäße Verfahren zur Entspiegelung der Oberfläche eines Kunststoffsubstrats ist ein mehrstufiger Prozess. Zunächst wird mit Hilfe eines Sputterverfahrens eine dünne dielektrische Grundschicht auf das Substrat aufgebracht. Die auf diese Weise besputterte Kunststoffoberfläche wird anschließend durch reaktives Plasmaätzen bearbeitet; dabei wird auf der Kunststoffoberfläche eine Struktur erzeugt, die entspiegelnd wirkt. Anschließend wir die strukturierte Kunststoffoberfläche mit einer Schutzschicht versehen, durch die die modifizierte Kunststoffoberfläche mechanisch stabilisiert wird und welche zusätzlich eine Optimierung der beiden ersten Prozessschritte bewirkt.

Der Auftrag der Grundschicht erfolgt durch ein plasmaunterstütztes reaktives Sputterverfahren. Die Grundschicht umfasst vorzugsweise Oxide, Fluoride oder Nitride der Elemente Ti, Zr, Cr, Si, AI, Ta, Nb und/oder Hf. Die Dicke der Grundschicht beträgt vorzugsweise zwischen 1 und 5 nm, besonders bevorzugt zwischen 1 und 3 nm. - Das Plasmaätzen erfolgt vorzugsweise in einer Sauerstoff enthaltenden Atmosphäre.

Die Schutzschicht wird vorzugsweise ebenfalls - wie die Grundschicht - durch ein plasmaunterstütztes reaktives Sputterverfahren appliziert. Als Werkstoffe für die Schutzschicht haben sich insbesondere Oxide der Elemente Si und/oder Al als zweckmäßig herausgestellt. Die Dicke der Schutzschicht beträgt vorzugsweise zwischen 5 und 50 nm, besonders bevorzugt zwischen 10 und 30 nm.

Zusätzlich zu der Schutzschicht kann eine weitere Schicht (sogenanntes Topcoat) aufgebracht werden, um die Kunststoffoberfläche mit einer definierten Oberflächenspannung zu versehen und insbesondere, um superhydrophobe Eigenschaften zu erzielen. Eine solche hydrophobe Schicht hat einen schmutz- und/oder wasserabweisenden Effekt. Die hydrophobe Schicht wird vorteilhafterweise mittels Plasmapolymerisation aufgebracht. Die Schichtdicke des Topcoats beträgt typischerweise zwischen 1 und 20 nm, bevorzugt zwischen 3 und 10 nm.

Um das Kunststoffsubstrat zu schonen, werden die Verfahrensschritte vorzugsweise bei niedrigen Substrattemperaturen < 100° C, vorzugsweise < 70° C, besonders bevorzugt 60°C durchgeführt.

Im Folgenden wird die Erfindung anhand eines in den Figuren dargestellten Ausführungsbeispiels näher erläutert. Dabei zeigen:
- Fig. 1: eine schematische Darstellung einer erfindungsgemäßen Vorrichtung zur Oberflächenbehandlung eines Kunststoffsubstrats;
- Fig. 1a: eine schematische Darstellung einer bei einer Vorrichtung nach Fig. 1 eingesetzten Plasmaquelle;
- Fig. 2: ein Diagramm der Änderung des Transmissionskoeffizienten und der Plasmaätzzeit eines Substrats aus PMMA 8H, als Funktion der Schichtdicke einer vor der Plasmabehandlung aufgetragenen Grundschicht;
- Fig. 3: ein Diagramm der Änderung des Transmissionskoeffizienten und der Plasmaätzzeit eines Substrats aus PMMA 8H, als Funktion der Plasmaleistung;
- Fig. 4: ein Diagramm der Änderung des Transmissionskoeffizienten und der Plasmaätzzeit eines Substrats aus PMMA 8H, als Funktion der Ionenenergie;
- Fig. 5: ein Diagramm des Transmissionskoeffizienten eines Substrats aus PMMA 8H als Funktion der Wellenlänge, für mehrere Proben, die einer Plasmaätzbehandlung mit unterschiedlicher Plasmaleistung unterzogen wurden;
- Fig. 6: ein Diagramm der Reflektivitäten der Proben der Fig. 5 als Funktion der Wellenlänge;
- Fig. 7: ein Diagramm der Summe aus Transmissionskoeffizient und Reflektivität der Proben der Figur 5 in Abhängigkeit von der Wellenlänge.

In den Zeichnungen sind einander entsprechende Elemente mit denselben Bezugszeichen bezeichnet. Die Zeichnungen stellen ein schematisches Ausführungsbeispiel dar und geben keine spezifischen Parameter der Erfindung wieder. Weiterhin dienen die Zeichnungen lediglich zur Erläuterung einer vorteilhaften Ausführungsform der Erfindung und sollen nicht in einer solchen Weise interpretiert werden, dass sie den Schutzbereich der Erfindung einengen.

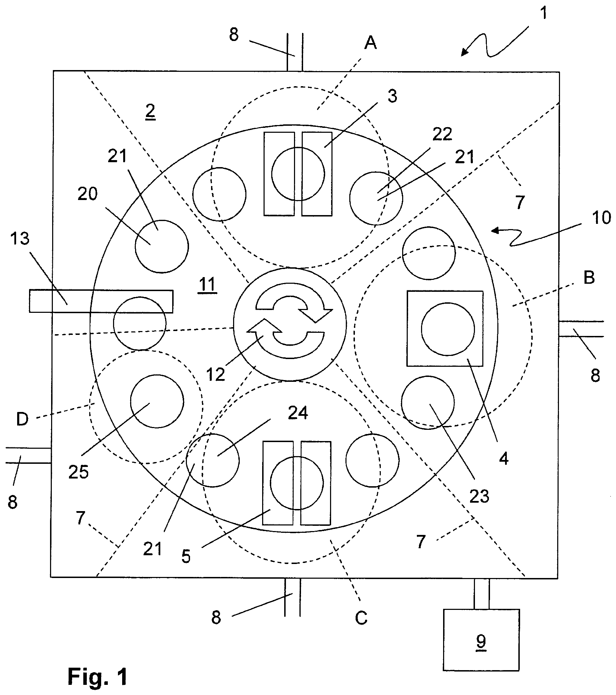

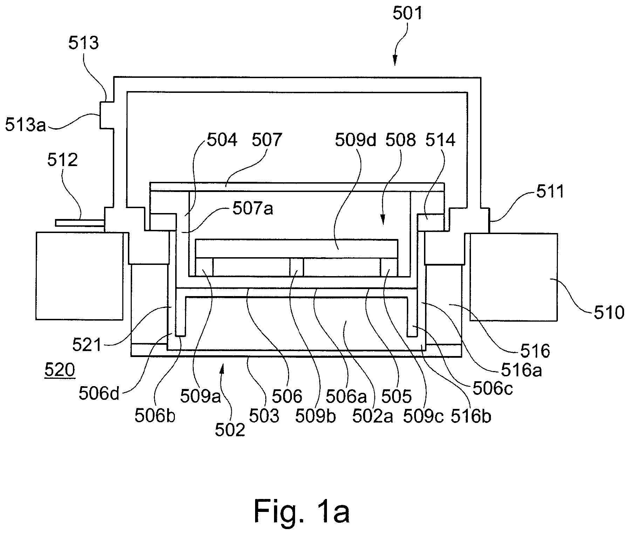

Figur 1 zeigt eine schematische Ansicht einer Vorrichtung 1 zur Herstellung einer reflektionsmindernden Schicht auf einer Oberfläche 21 eines Substrats 20. Figur 1 zeigt mehrere Substratscheiben 20, die in einer kreisförmigen Anordnung auf einem Drehteller 11 angeordnet sind, von denen aus Gründen der Übersichtlichkeit aber nur einige mit Bezugszeichen versehen sind Die Substratscheiben 20 bestehen aus einem Kunststoff, beispielsweise aus PMMA.

Die Vorrichtung 1 umfasst eine Vakuumkammer 2, in deren Innenraum mehrere Prozessstationen A, B, C angeordnet sind. In Prozessstation A befindet sich eine erste Sputtereinrichtung 3, in der unter Verwendung eines plasmaunterstützten reaktiven Sputterverfahrens eine Grundschicht 22 auf die Substratoberfläche 21 aufgetragen wird. Die Sputtereinrichtung 3 ist vorzugsweise ein Magnetronquellensystem mit zwei nebeneinander angeordneten Magnetonanordnungen mit zwei nebeneinander angeordneten Niob-Targets. Den Targets sind Shutter zugeordnet, mit denen die Sputtereinrichtung gegenüber den Substraten 20 isoliert werden kann.

Die zweite Prozessstation B enthält eine Plasmaquelle 4, mit der eine Plasmaätzbehandlung der beschichteten Substratoberfläche 21 durchgeführt wird, wodurch die Substratoberfläche eine Nanostrukturierung 23 erhält. Die Plasmaquelle 4 umfasst ein Plasmagefäß mit einer Extraktionselektrode und einer HF- Anregungselektrode mit einer Anregungsfläche, die über ein Anpassungsnetzwerk mit einem HF-Generator verbunden ist. Die Anregungselektrode kann thermisch an ein Kältereservoir gekoppelt sein und wird bei Raumtemperatur betrieben. Die Anregungselektrode kann beispielsweise als Aluminiumelektrode ausgebildet sein, die auf einer wasserkühlten Kupferplatte gebondet ist.

Zwischen der Anregungsfläche und der Extraktionselektrode liegt ein Plasmaraum, in dem en Plasma angeregt werden kann, wobei die Fläche der Extraktionselektrode und der Anregungsfläche derart gestaltet sind, dass nahezu die gesamte Hochfrequenzspannung an der Extraktionselektrode abfällt. Weiterhin ist eine Magnetvorrichtung zur Erzeugung eines Magnetfeldes vorgesehen, die einen magnetischen Nord- und einen magnetischen Südpol aufweist, die jeweils auf einer dem Plasmaraum abgewandten Seite hinter der Anregungselektrode angeordnet und in das Innere des Plasmaraums gerichtet sind. Auf diese Weise wird ein gekrümmtes, in das Innere des Plasmaraums hineinragendes Magnetfeld ausgebildet. Zwischen Nord- und Südpol wird ein tunnelartiger Bereich gebildet, in dem geladene Teilchen gehalten werden und entlang welchem sie sich ausbreiten können. Ionendichte und Ionenenergie werden über die Magnetfeldstärke der Plasmaquelle eingestellt. Eine solche Plasmaquelle 4 ist beispielsweise in der DE 10 2009 018 912 A1 beschrieben, deren gesamter Offenbarungsgehalt in die vorliegende Anmeldung durch Bezugnahme übernommen wird.

Der Plasmaquelle 4 ist ebenfalls ein Shutter zugeordnet, so dass eine Einwirkung der Plasmaquelle 4 auf das Substrat 20 gezielt ein- und ausgeschaltet werden kann. In einer dritten Prozessstation C wird mittels einer zweiten Sputtereinrichtung 5 eine Schutzschicht 24 auf die bearbeitete Substratoberfläche 21 aufgebracht. Die zweite Sputtereinrichtung 5 ist vorzugsweise identisch zur ersten Sputtereinrichtung 3 und verfügt ebenfalls über Shutter. In einer Prozessstation D kann zusätzlich ein hydrophobes Topcoat 25 als weitere Schutzschicht aufgebracht werden, um die Beschichtung unempfindlich gegenüber Schmutz und Feuchtigkeit zu machen.

Die Prozessstationen A, B, C, D sind vorzugsweise durch Blenden 7 gegeneinander abgeschirmt und nur durch Schlitze in diesen Blenden 7 miteinander verbunden. Auf diese Weise wird eine vakuummäßige Trennung der Prozessstationen A, B, C, D erreicht.

Zur Evakuierung der Vakuumkammer 2 ist mindestens eine Vakuumpumpe 9 vorgesehen. Weiterhin enthält die Vakuumkammer 2 mindestens einen Anschluss 8 zum gezielten Einleiten von Prozessgasen; vorzugsweise besitzt jede Prozessstation A, B, C, D einen eigenen Anschluss 8 zum selektiven Einleiten der in dieser Station benötigten Prozessgase. Die Partialdrücke der Prozessgase können auf diese Weise im Wesentlichen unabhängig voneinander eingestellt werden. Vorzugsweise wird eine Mischung eines Schutzgases wie z.B. Argon und ein Reaktivgas, vorzugsweise Sauerstoff, verwendet.

Wie in Figur 1 dargestellt, können mit der erfindungsgemäßen Vorrichtung 1 mehrere Substrate 20 gleichzeitig oberflächenbehandelt werden. Die Substrate 20 sind auf einer Fördervorrichtung 10 angeordnet, die im vorliegenden Ausführungsbeispiel die Gestalt des angetriebenen Drehtellers 11 hat. Mittels dieses Drehtellers 11 werden die Substrate 20 auf einer Kreisbahn nacheinander durch die Prozessstationen A, B, C und D befördert (Pfeil 12) und können insbesondere mehrfach durch den Wirkungsbereich dieser Prozessstationen hindurchbewegt werden, wodurch eine besonders gleichförmige Beaufschlagung der Substratoberflächen 21 erreichbar ist. Der Transport von einer Prozessstation zur nächsten erfolgt im Inneren der Vakuumkammer 2, ohne dass eine Belüftung der Vakuumkammer 2 erfolgen muss. Anstelle des Drehtellers 11 kann auch eine Trommelvorrichtung zum Transport der Substrate 20 verwendet werden.

Eine Messeinrichtung 13 dient zum In-Situ-Monitoring der behandelten Substratoberfläche 21, insbesondere zur Messung der Transmission und/oder Reflektivität der Substratoberfläche. Die Messeinrichtung 13 ermöglicht eine Überprüfung der optischen Eigenschaften der auf das Substrat 20 aufgebrachten Beschichtungen und kann insbesondere zur Überwachung der Schichtdicken der auf dem Substrat 20 aufwachsenden Schichten verwendet werden.

Mit der Vorrichtung 1 kann durch reaktives Sputtern und Plasmaätzen die Oberfläche eines Kunststoffsubstrats 20 in einer solchen Weise modifiziert werden, dass die Reflektion an dieser Oberfläche breitbandig reduziert wird.

Zur Durchführung der Behandlung werden die zu behandelnden Substratscheiben 20 durch eine (in Figur 1 nicht gezeigten) Schleuse in die Vakuumkammer 2 eingeführt und auf dem Drehteller 11 positioniert. Anschließend wird die Vakuumkammer 2 geschlossen und in Prozessstation A geeignete Partialdrücke für Inertgas (insbesondere Argon) und Reaktivgas (z.B. Sauerstoff) eingestellt. Die Sputtereinrichtung 3 wird in einen definierten Arbeitspunkt eingestellt, wobei zur Stabilisierung des Prozesses die Shutter geschlossen sind. Der Drehteller 11 der Fördervorrichtung 10 wird auf eine Sollgeschwindigkeit beschleunigt. Dann wird mit der Beschichtung des Substrats 20 begonnen. Hierzu werden die Shutter geöffnet, so dass mit Hilfe der Sputtereinrichtung 3 die dünne Grundschicht 22 auf die Substratoberflächen 21 abgeschieden wird. Die gewünschte Schichtdicke kann über eine Beschichtungszeit bzw. über eine Anzahl von Rotationen des Drehtellers 11 kontrolliert werden.

Eine bevorzugte Ausführungsform der Plasmaquelle wird im Folgenden genauer dargestellt.

Figur 1a zeigt in schematischer Darstellung einen Querschnitt einer in eine Vakuumkammer 510 eingebauten erfindungsgemäßen HF- Plasmaquelle 501 mit einem Plasmagefäß 502, einer Extraktionselektrode 503 und einer HF-Elektrodeneinrichtung 504. Über eine Gaszuführungseinrichtung 512 können Prozess- und Reaktivgase, wie Argon und Sauerstoff in das Plasmagefäß 502 eingebracht werden.

Das Plasmagefäß 502 weist eine Vorderseite und eine Rückseite auf, zwischen denen der Plasmaraum 502a liegt. Das Plasmagefäß 502 weist ferner Seitenwände 516 auf, die in das Innere 520 der Vakuumkammer 510 ragen und an deren Stirnseiten die die Vorderseite des Plasmagefäß 502 bildende Extraktionselektrode 503 angebracht ist, die damit den Plasmaraum 502a gegenüber dem Inneren 520 der Vakuumkammer permeabel begrenzt. Die Extraktionselektrode 502 kann auch gekrümmt ausbildet sein.

Das Plasmagefäß 502 kann in einer senkrechten Ebene zu der Zeichenebene der Figur 1a eine rechteckige oder runde Form aufweisen. Die in Figur 1a planare Bodenfläche der Anregungselektrode 506 kann auch gegenüber der Extraktionselektrode konkav oder konvex ausgebildet sein. Es versteht sich, dass auch andere Formen des Plasmagefäßes 502 vorstellbar sind und von der Erfindung umfasst werden.

Die Plasmaquelle ist mit einem Flansch 511 in einer Öffnung einer Vakuumkammerwand 510 befestigt. Extraktionsgitter 503 sowie die Wandung 516 sind im Ausführungsbeispiel der Figur 1a elektrisch mit der Vakuumwandkammerwand 510 verbunden und liegen auf Massepotential.

Die Plasmaquelle 501 weist eine teilweise außerhalb des Plasmagefäßes 502 angeordnete HF-Elektrodeneinrichtung 504 auf mit einer Elektrodenhalterung 507, die gegenüber dem Plasmagefäß 502 mittels eines Isolatorelements 514 galvanisch isoliert mit den Seitenwänden 516 des Plasmagefäß 502 verbunden ist und ein plattenförmiges Element 505 umfasst, das von Halteelementen 507a gehalten ist, die in das Innere des Plasmagefäßes 502 hineinragen. Die Elektrodenhalterung 507 hat im Querschnitt eine Badenwannen- ähnliche Form. Die Elektrodeneinrichtung 504 ist rückseitig gegenüber der Umgebung durch eine Schutzabdeckung 513 getrennt, wobei HF-Leistung über eine mit einem HF-Generator verbindbare oder verbundene HF- Einspeisung 513a an die HF-Elektrodeneinrichtung 504 anlegbar ist oder angelegt wird. Ein HF-Anpassungsnetzwerk ist zwar vorhanden, in der Zeichnung jedoch nicht dargestellt.

Die Vorderseite des plattenförmigen Elements 505 ist zum Inneren 520 der Vakuum-Kammer hin orientiert. An der Vorderseite des plattenförmigen Elementes 505 ist die topfartige Anregungselektrode 506 angebracht, die auf ihrer zum Inneren 520 der Vakuum-Kammer hin orientierten Innenseite 506a eine Anregungsfläche aufweist und mit ihrer Außenseite 506d zumindest teilweise in Kontakt mit der Vorderseite des plattenförmigen Elementes 505 steht. Die Anregungselektrode 506 weist einen planaren Boden und daran angebrachte Seitenwände 506c mit Endbereichen (Stirnflächen) 506b auf, die in den Plasmaraum 502 hineinragen. Bevorzugt sind Anregungselektrode 506 und Element 505 gebondet, damit ein guter Wärme-und elektrischer Kontakt zwischen dem plattenförmigen Element 505 und der Anregungselektrode 506 gewährleistet ist. Die Anregungselektrode 506 kann aus Aluminium bestehen und das Element 505 kann als wassergekühlte Kupferplatte ausgebildet sein. Die Seitenwände 506c werden durch eine Wandung der Anregungselektrode 506 gebildet.

Die Seitenwände 516 des Plasmagefäßes und die Seitenwände 506c der Anregungselektrode sind nahe zueinander liegend angeordnet, voneinander durch einen Spalt 521 getrennt, der so dimensioniert ist, dass sich bei Betrieb der Plasmaquelle zwischen der Anregungselektrode 506 und der Seitenwand 516 kein Plasma ausbilden kann. Die Seitenwände 516 des Plasmagefäßes 502 realisieren daher im Bereich des Spalts 521 eine Dunkelraumabschirmung mit einer Abschirmungsfläche 516a der Anregungselektrode 506.

Die Seitenwände 516 des Plasmagefäßes 502 ragen in Richtung des Inneren 520 der Vakuumkammer mit einem Bereich über die Seitenwände 506c hinaus, so dass bei Betrieb der Plasmaquelle 501 der Bereich der Seitenwände 516, der über den Endbereich 506b der Seitenwände 506c hinausragt in Kontakt mit dem Plasma steht und eine Plasmaelektrode mit einer Plasmaelektrodenfläche 516b bildet.

Im Betrieb der Plasmaquelle 501 wird die Größe des DC - Selfbias zwischen der Anregungselektrode 506 und der Extraktionselektrode bestimmt durch das Größenverhältnis der Anregungsflächen 506a und 506c zu der Fläche der Extraktionselektrode 503 und der Größe der Plasmaelektrodenfläche 516b, d.h. der in Kontakt mit dem Plasma stehenden Teile der Seitenwände 516 des Plasmagefäßes 502.

Auf der Rückseite der Anregungsfläche 506a und des plattenförmigen Elementes 505 ist die Magnetvorrichtung 508 mit Magneten 509a, 509b, 509c sowie mit einem Pohlschuh 509d angeordnet. Die Magnete 509a, 509b, 509c umfassen jeder einen magnetischen Nord- und einen magnetischen Südpol, die mit alternierender Polarität angeordnet und in das Innere des Plasmaraumes 502a gerichtet sind, so dass sich ein gekrümmtes in das Innere des Plasmaraumes hineinragendes Magnetfeld ausbildet, wie an sich beispielsweise aus der

DE 241 728 8 C2 oder der DE 243 183 2 B2 bekannt ist. Die Magnete 509a, 509b, 509c können als Permanent-Magnete oder als Solenoide, die an eine Stromversorgung angeschlossen oder anschließbar sind, ausgebildet sein.

Die beschriebene Plasmaquelle liefert schon bei kleinen Plasmaleistungsdichten von 0,5 - 1,5W/cm² hohe Stromdichten von 0,5 - 0,8mA/cm² bei lonenenergien von 300 - 400eV. Damit kann ein hocheffektives Ätzen erreicht werden, das mit geringer thermischer Belastung verbunden ist.

Die Beschichtung erfolgt durch reaktives Sputtern eines Metalls (z.B. AI, Nb, Hf, Ta, Ti, Zr), einer Legierung (z.B. TiNb) oder eines Halbleiters (z.B. Si) in einer Sauerstoffatmosphäre, so dass auf die Substratoberfläche eine Oxidschicht 22 als Grundschicht aufgetragen wird. Als besonders vorteilhaft hat sich ZrO₂ herausgestellt. Die Dicke der ZrO₂-Grundschicht liegt vorteilhafterweise zwischen 1 nm und 3 nm.

Ist die gewünschte Schichtdicke der Grundschicht 22 erreicht, dann wird die Substratoberfläche 21 mit Hilfe der Plasmaquelle 4 in Prozessstation B einer Plasmaätzbehandlung unterzogen. Im Vorfeld der Plasmabehandlung wird über den Einlass 8 der Prozessstation B ein Reaktivgas bzw. eine Gasmischung in einer geeigneten Konzentration eingeleitet und das Plasma gezündet. Die Plasmaquelle 4 wird vorteilhafterweise mit einer Leistung zwischen 100W und 400 W betrieben, bei einer konstanten Sauerstoffflussrate von 10 sccm/min. Sind die gewünschten Verfahrensparameter erreicht, dann wird der Shutter der Prozessstation B geöffnet und mit der Plasmabehandlung begonnen.

Wenn die gewünschte Modifikation der Oberfläche erreicht wurde, wird der Shutter der Prozessstation B geschlossen, und das Substrat wird einer weiteren Beschichtung durch reaktives Sputtern mit Hilfe der in Prozessstation C angesiedelten zweiten Sputtereinrichtung 5 unterzogen. Dabei wird auf die Substratoberfläche eine Schutzschicht 24 abgeschieden. Als Schutzschicht 24 kann insbesondere eine SiO₂-Schicht mit einer Schichtdicke von etwa 20 nm verwendet werden.

Die Ergebnisse jedes einzelnen Prozessschritts kann mit Hilfe der Messeinrichtung 8 überprüft werden, beispielsweise durch eine Messung der optischen Transmission der Substratscheiben 20.

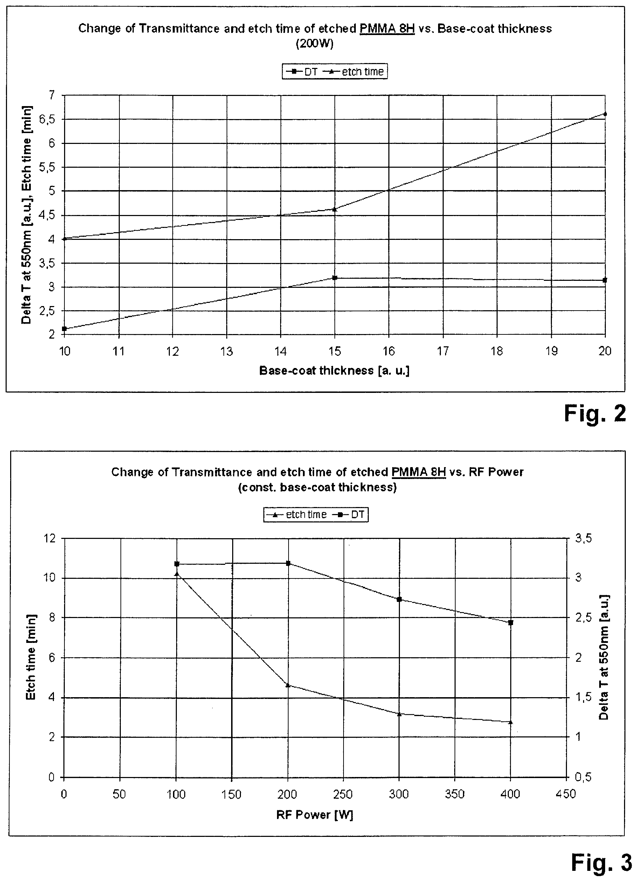

Konkrete Messungen an Substraten aus PMMA 8H, die durch ein solches Verfahren beschichtet und oberflächenbehandelt wurde, sind in Figuren 2 bis 7 gezeigt. Es versteht sich, dass auch andere Kunststoffmaterialien, wie beispielsweise Polycarbonate, verwendet werden können.

Das Diagramm der Figur 2 zeigt die Abhängigkeit der zur Erzeugung einer gewünschten Oberflächenstrukturierung notwendigen Plasmaätzzeit (Bearbeitungszeit in Prozessstation B) als Funktion der Schichtdicke der (in Prozessstation A aufgetragenen) Grundschicht bei konstanter Leistung der Plasmaquelle (200W). Weiterhin ist die Änderung der Transmission als Funktion der Schichtdicke der Grundschicht dargestellt. Es ist ersichtlich, dass die Ätzzeit bei größerer Schichtdicke der Grundschicht zunimmt; während die Transmission näherungsweise konstant ist.

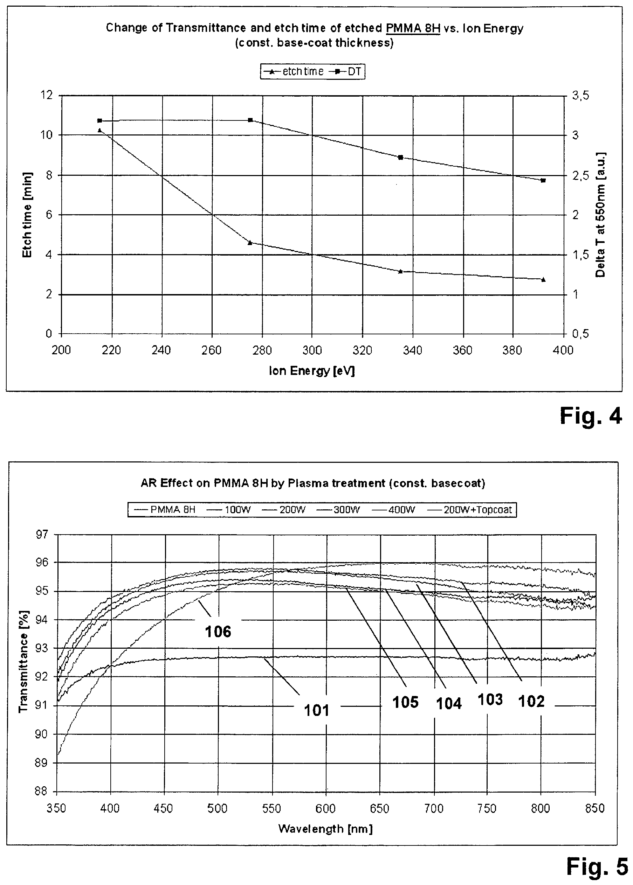

Figur 3 stellt die Abhängigkeit der Plasmaätzzeit von der Leistung der Plasmaquelle dar. Dieses Diagramm zeigt, dass durch eine Erhöhung der Plasmaleistung eine Reduktion der Plasmaätzzeit erreicht werden kann. Allerdings führt eine Erhöhung der Plasmaleistung oberhalb 200 W zu einer Abnahme der Transmissivität des behandelten Substrats. Wie aus Figur 4 ersichtlich, führt auch eine Erhöhung der Ionenenergie zu einer Reduktion der Plasmaätzzeit, allerdings hat auch dies eine Reduktion der Transmissivität des auf diese Weise behandelten Substrats zur Folge.

Figur 5 zeigt ein Diagramm der Abhängigkeit des Transmissionskoeffizienten von der Wellenlänge bei Substraten, welche zunächst mit einer Grundbeschichtung versehen und anschließend plasmageätzt wurden. Die unterschiedlichen Kurven entsprechen dabei Ätzbehandlungen mit unterschiedlichen Plasmaleistungen. Wird dieses Substrat nicht plasmabehandelt, so liegt die Transmissivität im gesamten gezeigten Wellenlängenbereich bei 92% - 93% (Kurve 101). Mit einer Plasmabehandlung können - je nach Leistung der Plasmaquelle - Transmissivitäten um die 95% - 96% erreicht werden (Kurven 102 - 105). Eine zusätzliche Topcoat-Beschichtung führt im blauen Spektralbereich zu einer geringeren Transmission, erhöht aber die Transmission für Licht mit größeren Wellenlängen Spektralbereich (Kurve 106).

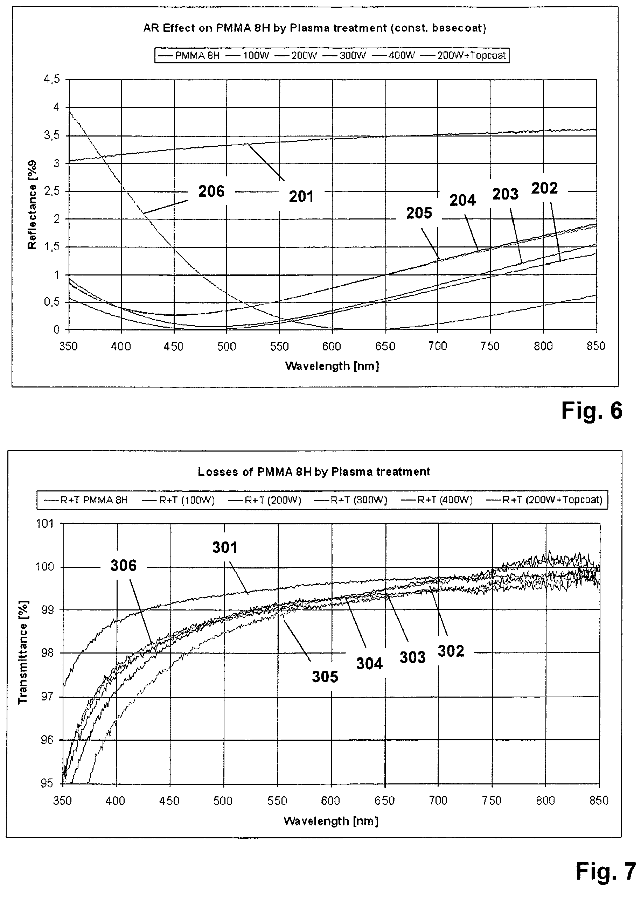

Figur 6 zeigt ein Diagramm der Abhängigkeit der Reflektivität von der Wellenlänge für die Proben der Figur 5. Kurve 201 entspricht der Reflektivität einer Probe, die keiner Plasmabehandlung ausgesetzt wurde; hier liegt die Reflektivität im betrachteten Wellenlängenbereich bei etwa 3%. Wird die Probe einer Plasmabehandlung unterzogen, so wird die Reflektivität im betrachteten Wellenlängenbereich auf 1% - 2% reduziert (Kurven 202 - 205). Durch eine zusätzliche Topcoat-Beschichtung hat zwar eine Erhöhung der Reflektivität im blauen Spektralbereich zur Folge, führt jedoch bei höheren Wellenlängen zu einer erheblichen Reduktion der Reflektivität (Kurve 206).

Figur 7 schließlich zeigt die Summe aus Transmissionskoeffizient und Reflektivität der Proben der Figur 5 in Abhängigkeit von der Wellenlänge. Hier gehört Kurve 301 zu der Probe, die keiner Plasmabehandlung ausgesetzt wurde. Kurven 302 - 305 gehören zu Proben, die mit unterschiedlichen Plasmaleistungen geätzt wurden. Kurve 306 entspricht einer Messung an der Probe, die zusätzlich zu einer Plasmabehandlung bei 200 W mit einer Topcoat-Beschichtung versehen wurde.

## Patentansprüche

1. Verfahren zur Herstellung einer reflektionsmindernden Schicht auf einer Oberfläche (21) eines Kunststoffsubstrats (20), mit den Verfahrensschritten
- Aufbringen einer dielektrischen Grundschicht (22) auf die Oberfläche (21) des Substrats (20) in einer ersten Sputtereinrichtung (3);
- Behandeln der beschichteten Oberfläche (21) durch Plasmaätzen mittels einer Plasmaquelle (4);
- Aufbringen einer Schutzschicht (24) auf die behandelte Oberfläche (21) in einer zweiten Sputtereinrichtung (5), wobei, das Kunststoffsubstrat (20) mittels einer Fördervorrichtung (10) zwischen den in einer gemeinsamen Vakuumkammer (2) angeordneten Bearbeitungseinrichtungen (3, 4, 5) bewegt wird und wobei die Leistungsdichte der Plasmaquelle bezogen auf die Fläche der Extraktionselektrode 0,5 - 1,5W/cm² beträgt.

2. Verfahren nach Anspruch 1,
**dadurch gekennzeichnet, dass** das Aufbringen der Grundschicht (22) und/oder der Schutzschicht (24) mittels eines plasmaunterstützten reaktiven Sputterverfahrens erfolgt.

3. Verfahren nach Anspruch 1 oder 2,
**dadurch gekennzeichnet, dass** die Grundschicht (22) aus einem Oxid, Nitrid oder Fluorid der Elemente Ti, Zr. Cr, Si, AI, Ta, Nb und/oder Hf besteht und eine Schichtdicke zwischen 1 nm und 5 nm hat.

4. Verfahren nach einem der vorstehenden Ansprüche,
**dadurch gekennzeichnet, dass** die Modifikation der beschichteten Oberfläche (21) mittels reaktiven Plasmaätzens, insbesondere in einer Sauerstoff enthaltenden Atmosphäre erfolgt.

5. Verfahren nach einem der vorstehenden Ansprüche,
**dadurch gekennzeichnet, dass** das Aufbringen der Schutzschicht (24) ebenfalls mittels eines plasmaunterstützten reaktiven Sputterverfahrens erfolgt.

6. Verfahren nach einem der vorstehenden Ansprüche,
**dadurch gekennzeichnet, dass** die Schutzschicht (24) aus einem Oxid, Nitrid oder Fluorid der Elemente Si und/oder AI besteht und eine Schichtdicke zwischen 5 nm und 50 nm hat.

7. Verfahren nach einem der vorstehenden Ansprüche,
**dadurch gekennzeichnet, dass** zusätzlich zu der Schutzschicht (24) eine hydrophobe weitere Schicht (25) aufgebracht wird.

8. Verfahren nach Anspruch 7,
**dadurch gekennzeichnet, dass** die hydrophobe weitere Schicht (25) eine Schichtdicke zwischen 1 nm und 20 nm hat.

9. Verfahren nach einem der vorstehenden Ansprüche,
**dadurch gekennzeichnet, dass** die Verfahrensschritte bei einer Substrattemperatur < 100° C, vorzugsweise < 70° C, durchgeführt werden.

10. Verfahren nach Anspruch 9, **dadurch gekennzeichnet, dass** die Anregungselektrode bei einer Temperatur zwischen 15°C und 45°C betrieben wird.

11. Verfahren nach einem der vorstehenden Ansprüche, **dadurch gekennzeichnet, dass** das Verfahren bei einem Abstand zwischen einem Gitter der Plasmaquelle und der Substratoberfläche von 50 - 100mm durchgeführt wird.

12. Verfahren nach einem der vorstehenden Ansprüche, **dadurch gekennzeichnet, dass** die Plasmaleistung der Plasmaquelle zwischen 200 Watt bis 400 Watt beträgt.

13. Vorrichtung (1) zur Durchführung der Schritte des Verfahrens nach eine der vorstehenden Ansprüche zur Herstellung einer reflektionsmindernden Schicht auf einer Oberfläche (21) eines Kunststoffsubstrats (20), wobei die Vorrichtung aufweist:
- das Kunststoffsubstrat (20),
- eine erste Sputtereinrichtung (3) zum Aufbringen einer Grundschicht (22) auf die Oberfläche (21) des Kunststoffsubstrats (20),
- eine Plasmaquelle (4) zur Plasmaätzbehandlung der beschichteten Substratoberfläche (21),
- vorzugsweise eine zweite Sputtereinrichtung (5) zum Aufbringen einer Schutzschicht (24) auf die Substratoberfläche (21),
- mindestens einen Einlass (8) für mindestens ein Prozessgas,
- einer Vakuumkammer (2), in der die Bearbeitungseinrichtungen (3, 4, 5) angeordnet sind, und
- eine Fördervorrichtung (10) zum Bewegen des Substrats (20) zwischen den Bearbeitungseinrichtungen (3, 4, 5) im Innenraum der Vakuumkammer (2) und
- wobei die Leistungsdichte der Plasmaquelle bezogen auf die Fläche der Extraktionselektrode 0,5 - 1,5W/cm² beträgt.

14. Vorrichtung (1) nach Anspruch 13 ,
**dadurch gekennzeichnet,**
**dass** die Fördervorrichtung (10) ein Drehteller (11) oder eine Trommel ist.

15. Vorrichtung (1) nach Anspruch 13 oder 14,
**dadurch gekennzeichnet,**
**dass** die Plasmaquelle (4) einen Plasmaraum, eine Anregungselektrode und eine Magnetvorrichtung mit einem magnetischen Nord- und einem magnetischen Südpol enthält, wobei die beiden magnetischen Pole jeweils auf einer einem Plasma abgewandten Seite hinter der Anregungselektrode angeordnet und in das Innere des Plasmaraums gerichtet sind, so dass ein gekrümmtes in das Innere des Plasmaraums hineinragendes Magnetfeld und ein tunnelartiger Bereich gebildet wird, in dem geladene Teilchen gehalten werden können und entlang welchem sie sich ausbreiten können, wobei die Plasmaquelle (4) insbesondere eingerichtet ist für einen Betrieb mit einer Plasmaleistung zwischen 200 Watt bis 400 Watt.

16. Vorrichtung (1) nach Anspruch 15, **dadurch gekennzeichnet, dass** die Anregungselektrode mit einer Anregungsfläche, die über ein Anpassungsnetzwerk mit einem HF-Generator verbindbar oder verbunden ist, wobei zwischen Anregungsfläche und Extraktionselektrode ein Plasmaraum liegt, in dem ein Plasma anregbar ist und wobei die Größe der Fläche der Extraktionselektrode und der Anregungsfläche derart gewählt sind, dass nahezu die gesamte Hochfrequenzspannung an der Extraktionselektrode abfällt,
wobei die Magnetfeldvorrichtung als planares Magnetron ausgebildet ist, welches zumindest einen magnetischer Nord- und einen magnetischen Südpol aufweist, die jeweils auf einer dem Plasmaraum abgewandten Seite hinter der Anregungselektrode angeordnet und in das Innere des Plasmaraums gerichtet sind.

17. Vorrichtung nach Anspruch 14 oder 16, **dadurch gekennzeichnet, dass** die Anregungselektrode bei einer Temperatur zwischen 15°C und 45°C betrieben ist.

18. Vorrichtung (1) nach einem der Ansprüche 12 bis 17,
**dadurch gekennzeichnet,**
**dass** die Vorrichtung (1) eine Messeinrichtung (8) zur In-situ-Messung der Transmission und/oder der Reflektion der Oberfläche (21) des Kunststoffsubstrats (20) umfasst.

## Claims

1. A method for producing a reflection-reducing layer on a surface (21) of a plastic substrate (20), the method comprising the steps of:
- depositing a dielectric base layer (22) on the surface (21) of the substrate (20) in a first sputtering device (3);
- treating the coated surface (21) by plasma etching with a plasma source (4);
- depositing a protective layer (24) on the treated surface (21) in a second sputtering device (5),
wherein
the plastic substrate (20) is moved with a conveying device (10) between the processing means (3, 4, 5) arranged in a common vacuum chamber (2) and wherein
the power density of the plasma source relative to the area of the extraction electrode is 0.5-1.5 W/cm².

2. The method according to claim 1,
**characterized in that** the depositing of the base layer (22) and/or the protective layer (4) is performed by a plasma-enhanced reactive sputtering method.

3. The method according to claim 1 or 2,
**characterized in that** the base layer (22) consists of an oxide, nitride or fluoride of the elements Ti, Zr, Cr, Si, Al, Ta, Nb and/or Hf and has a layer thickness of between 1 nm and 5 nm.

4. The method according to any one of the preceding claims,
**characterized in that** the modification of the treated surface (21) is performed by reactive plasma etching, in particular in an oxygen-containing atmosphere.

5. The method according to any one of the preceding claims,
**characterized in that** the depositing of the protective layer (24) is also performed by a plasma-enhanced reactive sputtering method.

6. The method according to any one of the preceding claims,
**characterized in that** the protective layer (24) consists of an oxide, nitride or fluoride of the elements Si and/or Al and has a layer thickness of between 5 nm and 50 nm.

7. The method according to any one of the preceding claims,
**characterized in that** a hydrophobic further layer (25) is deposited in addition to the protective layer (24).

8. The method according to claim 7,
**characterized in that** the hydrophobic further layer (25) has a layer thickness of between 1 nm and 20 nm.

9. The method according to any one of the preceding claims,
**characterized in that** the method steps are performed at a substrate temperature of < 100° C, preferably < 70° C.

10. The method according to claim 9,
**characterized in that** the excitation electrode is operated at a temperature of between 15° C and 45° C.

11. The method according to any one of the preceding claims,
**characterized in that** the method is carried out with a distance between a grid of the plasma source and the substrate surface of 50-100 mm.

12. The method according to any one of the preceding claims,
**characterized in that** the plasma power of the plasma source is between 200 watts to 400 watts.

13. A device (1) for carrying out the steps of the method according to any one of the preceding claims for producing a reflection-reducing layer on a surface (21) of a plastic substrate (20), the device comprising:
- the plastic substrate (20),
- a first sputtering means (3) for depositing a base layer (22) on the surface (21) of the plastic substrate (20),
- a plasma source (4) for plasma etching treatment of the coated substrate surface (21),
- preferably a second sputtering means (5) for depositing a protective layer (24) on the substrate surface (21),
- at least one inlet (8) for at least one process gas,
- a vacuum chamber (2) in which the processing means (3, 4, 5) are arranged, and
- a conveying device (10) for moving the substrate (20) between the processing means (3, 4, 5) in the interior of the vacuum chamber (2) and
- wherein the power density of the plasma source, relative to the area of the extraction electrode, is 0.5-1.5 W/cm².

14. The device (1) according to claim 13,
**characterized in that**
the conveying device (10) is a rotating plate (11) or a drum.

15. The device (1) according to claim 13 or 14,
**characterized in that**
the plasma source (4) comprises a plasma space, an excitation electrode, and a magnet device having a magnetic north pole and a magnetic south pole, wherein the two magnetic poles are each arranged on a side facing away from a plasma behind the excitation electrode and directed into the interior of the plasma space to form a curved magnetic field projecting into the interior of the plasma space and a tunnel-like region in which charged particles can be held and propagated therealong, wherein the plasma source (4) is in particular configured to operate with a plasma power of between 200 watts to 400 watts.

16. The device (1) according to claim 15, **characterized in that** the excitation electrode has an excitation area which is connectable or connected to an RF generator via a matching network, wherein a plasma space in which a plasma can be excited lies between the excitation area and the extraction electrode and wherein the size of the area of the extraction electrode and the excitation area are selected such that substantially the entire radiofrequency voltage is dropped at the extraction electrode,
wherein the magnetic field device is configured as a planar magnetron having at least one magnetic north pole and one magnetic south pole which are each arranged on a side facing away from the plasma space behind the excitation electrode and are directed into the interior of the plasma space.

17. The device according to claim 14 or 16, **characterized in that** the excitation electrode is operated at a temperature of between 15° C and 45° C.

18. The device (1) according to any one of claims 12 to 17,
**characterized in that**
the device (1) comprises a measuring device (8) for in-situ measurement of the transmission and/or reflection of the surface (21) of the plastic substrate (20).

## Revendications

1. Procédé de fabrication d'une couche anti-reflets sur une surface (21) d'un substrat en matière plastique (20), comprenant les étapes de procédé
- d'application d'une couche de base (22) diélectrique sur la surface (21) du substrat (20) dans un premier dispositif de pulvérisation (3) ;
- de traitement de la surface (21) revêtue par gravure par plasma au moyen d'une source de plasma (4) ;
- d'application d'une couche protectrice (24) sur la surface (21) traitée dans un deuxième dispositif de pulvérisation (5),
où le substrat en matière plastique (20) est déplacé au moyen d'un dispositif de transport (10) entre les dispositifs de traitement (3, 4, 5) disposés dans une chambre à vide (2) commune et où la densité de puissance de la source de plasma est comprise entre 0,5 et 1,5W/cm² par rapport à la surface de l'électrode d'extraction.

2. Procédé selon la revendication 1,
**caractérisé en ce que** l'application de la couche de base (22) et/ou de la couche protectrice (24) est effectuée au moyen d'un procédé de pulvérisation cathodique réactive assistée par plasma.

3. Procédé selon la revendication 1 ou la revendication 2,
**caractérisé en ce que** la couche de base (22) consiste en un oxyde, nitrure ou fluorure des éléments Ti, Zr. Cr, Si, AI, Ta, Nb et/ou Hf, et a une épaisseur de couche comprise entre 1 nm et 5 nm.

4. Procédé selon l'une des revendications précédentes,
**caractérisé en ce que** la modification de la surface (21) revêtue est effectuée au moyen d'une gravure réactive par plasma, en particulier sous atmosphère contenant de l'oxygène.

5. Procédé selon l'une des revendications précédentes,
**caractérisé en ce que** l'application de la couche protectrice (24) est également effectuée au moyen d'un procédé de pulvérisation cathodique réactive assistée par plasma.

6. Procédé selon l'une des revendications précédentes,
**caractérisé en ce que** la couche protectrice (24) consiste en un oxyde, nitrure ou fluorure des éléments Si et/ou Al et a une épaisseur de couche comprise entre 5 nm et 50 nm.

7. Procédé selon l'une des revendications précédentes,
**caractérisé en ce qu'**une autre couche hydrophobe (25) est appliquée en plus de la couche protectrice (24).

8. Procédé selon la revendication 7,
**caractérisé en ce que** l'autre couche hydrophobe (25) a une épaisseur de couche comprise entre 1 nm et 20 nm.

9. Procédé selon l'une des revendications précédentes,
**caractérisé en ce que** les étapes de procédé sont exécutées à une température de substrat inférieure à 100 °C, préférentiellement inférieure à 70 °C.

10. Procédé selon la revendication 9, **caractérisé en ce que** l'électrode d'excitation est mise en service à une température comprise entre 15 °C et 45 °C.

11. Procédé selon l'une des revendications précédentes, **caractérisé en ce que** le procédé est exécuté avec un intervalle compris entre 50 et 100 mm entre une grille de la source de plasma et la surface de substrat.

12. Procédé selon l'une des revendications précédentes, **caractérisé en ce que** la puissance de la source de plasma est comprise entre 200 Watt et 400 Watt.

13. Dispositif (1) pour l'exécution des étapes du procédé de fabrication d'une couche anti-reflets sur une surface (21) d'un substrat en matière plastique (20) selon l'une des revendications précédentes, ledit dispositif présentant :
- le substrat en matière plastique (20),
- un premier dispositif de pulvérisation (3) pour l'application d'une couche de base (22) sur la surface (21) du substrat en matière plastique (20),
- une source de plasma (4) pour le traitement par gravure par plasma de la surface de substrat (21) revêtue,
- préférentiellement un deuxième dispositif de pulvérisation (5) pour l'application d'une couche protectrice (24) sur la surface du substrat (21),
- au moins une entrée (8) pour au moins un gaz de processus,
- une chambre à vide (2) dans laquelle sont disposés les dispositifs de traitement (3, 4, 5), et
- un dispositif de transport (10) pour le déplacement du substrat (20) entre les dispositifs de traitement (3, 4, 5) à l'intérieur de la chambre à vide (2) et
où la densité de puissance de la source de plasma est comprise entre 0,5 et 1,5W/cm² par rapport à la surface de l'électrode d'extraction.

14. Dispositif (1) selon la revendication 13 ,
**caractérisé en ce que** le dispositif de transport (10) est un plateau tournant (11) ou un tambour.

15. Dispositif (1) selon la revendication 13 ou la revendication 14, **caractérisé en ce que** la source de plasma (4) comprend une enceinte à plasma, une électrode d'excitation et un dispositif magnétique avec un pôle magnétique Nord et un pôle magnétique Sud, où les deux pôles magnétiques sont disposés chacun sur un côté opposé à un plasma derrière l'électrode d'excitation et dirigés vers l'intérieur de l'enceinte à plasma, de manière à former un champ magnétique courbe pénétrant à l'intérieur de l'enceinte à plasma et une zone en forme de tunnel, où des particules chargées peuvent être retenues et le long duquel elles peuvent se propager, la source de plasma (4) étant en particulier prévue pour une mise en service avec une puissance de plasma comprise entre 200 Watt et 400 Watt.

16. Dispositif (1) selon la revendication 15, **caractérisé en ce que** la source de plasma comprend une électrode d'excitation avec une surface d'excitation reliable ou reliée à un générateur HF par l'intermédiaire d'un circuit d'adaptation, une enceinte à plasma où un plasma est excitable étant disposée entre la surface d'excitation et l'électrode d'extraction, et la grandeur de la surface de l'électrode d'extraction et celle de la surface d'excitation étant sélectionnées de sorte que pratiquement toute la tension haute fréquence chute sur l'électrode d'extraction,
le dispositif magnétique étant réalisé comme magnétron planaire, lequel présente au moins un pôle magnétique Nord et un pôle magnétique Sud, disposés chacun sur un côté opposé à l'enceinte à plasma derrière l'électrode d'excitation et dirigés vers l'intérieur de l'enceinte à plasma.

17. Dispositif selon la revendication 14 ou 16, **caractérisé en ce que** l'électrode d'excitation est mise en service à une température comprise entre 15 °C et 45 °C.

18. Dispositif (1) selon l'une des revendications 12 à 17,
**caractérisé en ce que** ledit dispositif (1) comprend un dispositif de mesure (8) pour la mesure in situ de la transmission et/ou de la réflexion de la surface (21) du substrat en matière plastique (20).
